# Europäisches Patentamt

# European Patent Office

# Office européen des brevets

(19)

(11) Veröffentlichungsnummer: **0 100 949**
**B1**

(12)

# EUROPÄISCHE PATENTSCHRIFT

(45) Veröffentlichungstag der Patentschrift:
**10.12.86**

(51) Int. Cl.⁴: **G 01 R 1/04**, G 12 B 9/04,
G 01 D 11/24

(21) Anmeldenummer: **83107247.5**

(22) Anmeldetag: **23.07.83**

(54) **Vielfachmessgerät mit schwenkbarer Anzeige.**

(30) Priorität: **10.08.82 DE 3229688**

(43) Veröffentlichungstag der Anmeldung:
**22.02.84 Patentblatt 84/8**

(45) Bekanntmachung des Hinweises auf die Patenterteilung:
**10.12.86 Patentblatt 86/50**

(84) Benannte Vertragsstaaten:
**AT BE CH DE FR GB IT LI NL SE**

(56) Entgegenhaltungen:
**DE - A - 2 237 980**
**DE - A - 2 636 079**
**DE - A - 2 836 679**

(73) Patentinhaber: **METRAWATT GMBH,**
**Thomas-Mann-Strasse 16-20, D-8500 Nürnberg (DE)**

(72) Erfinder: **Hochreuther, Karl, Herbruckerstrasse 29,**
**D-8500 Nürnberg (DE)**
Erfinder: **Tragatschnig, Jörg, Weidenweg 3, A-5700 Zell**
**am See (AT)**

(74) Vertreter: **Kempe, Wolfgang, Dr. et al, c/o Metrawatt**
**GmbH Patentabteilung Postfach 3 51,**
**D-6800 Mannheim 1 (DE)**

ACTORUM AG

**Beschreibung**

Die Erfindung betrifft ein Vielfachmessgerät der im Oberbegriff des Anspruches 1 genannten Art.

Vielfachmessgeräte sollen robust aufgebaut, einfach zu handhaben und gut abzulesen sein, ausserdem ist auf die elektrische Sicherheit zu achten. Da Vielfachmessgeräte sowohl am Arbeitsplatz wie auch zur Montage bzw. Prüfung vor Ort verwendet werden, ist man bestrebt, sie so zu gestalten, dass sie den jeweiligen Arbeitsbedingungen angepasst werden können.

Dem entsprechend hilfreich ist eine Konstruktion, bei der zwei Gehäuseteile durch ein Scharnier miteinander verbunden sind, so dass das Gerät nach getaner Arbeit zusammengeklappt und in die Tasche gesteckt werden kann (DE-A 2 636 079). Weitere Vorteile bietet ein bekanntes Vielfachmessgerät, das nicht nur klappbar gestaltet ist, sondern mit Hilfe eines Traggurtes auch um den Hals getragen werden kann (DE-A 2 836 679, dieses Dokument belegt den Oberbegriff des Anspruchs 1). Dieses Gerät kann sowohl auf dem Arbeitstisch wie auch im umgehängten Zustand in eine für den Benutzer günstige Gebrauchslage geschwenkt werden. Durch den Gurt ist es möglich, das Vielfachmessgerät ohne Gebrauch der Hände zu tragen und bei einer Messung vor Ort die Hände für den Messvorgang freizuhaben.

Bekannte klappbare Vielfachmessgeräte haben jedoch den Nachteil, dass die Anzeigebaugruppe unterhalb der Hilfsbaugruppe zu liegen kommt, wenn das Vielfachmessgerät mittels eines Traggurtes um den Hals gehängt wird. Insbesondere dann, wenn das Gehäuse eher lang als breit gestaltet ist, ergibt sich ein erheblicher Abstand zwischen den Augen des Betrachters und der Anzeigeebene, so dass sich Ableseschwierigkeiten einstellen können.

Ein weiterer Nachteil dieser bekannten Vielfachmessgeräte ist, dass ihre Bedienfunktionen, insbesondere der Messbereichsschalter, auf der Oberfläche der senkrecht nach unten hängenden Hilfsbaugruppe angeordnet sind. Dadurch ist ein Blick auf die Bedienelemente und die hier gewählte Einstellung praktisch nur durch Anheben und Kippen des Messgerätes möglich. Dieser Nachteil wirkt sich besonders dann negativ aus, wenn das Vielfachmessgerät primär zur Prüfung vor Ort um den Hals getragen wird und relativ selten als Tischgerät dient.

Aufgabe der Erfindung ist es, zumindest einen der vorgenannten Nachteile der bekannten klappbaren Vielfachmessgeräte zu beseitigen. Diese Aufgabe wird durch die im Anspruch 1 gekennzeichneten Merkmale gelöst. Vorteilhafte Ausgestaltungen und Weiterbildungen der Erfindung sind in den Unteransprüchen gekennzeichnet.

Da Anzeigebaugruppe und Hilfsbaugruppe beidseitig zu einer gemeinsamen Ebene in verschiedene Stellungen schwenkbar sind, kann das Vielfachmessgerät noch besser den jeweiligen Arbeitsbedingungen angepasst werden. Soll das Gerät auf einem Arbeitstisch benutzt werden, so wird man die Anzeigebaugruppe so schwenken, dass der Blick über die Hilfsbaugruppe hinweg zur Anzeige geht. Die Hilfsbaugruppe ist in diesem Falle nicht störend, da man mit dem Kopf beliebig nahe an die Anzeige herangehen kann. Bei ungehängtem Gerät wird man die Anzeigebaugruppe nach der anderen Seite schwenken, so dass der Blick zuerst auf die Anzeige fällt, die Hilfsbaugruppe also unterhalb der Anzeigebaugruppe liegt. Die weiteren Merkmale der Erfindung verfolgen den Zweck, das Vielfachmessgerät in einer stabilen Hängelage zu halten, so dass die Anzeige auch dann im Blickfeld bleibt, wenn sich das Gerät nicht am Körper des Benutzers abstützen kann.

In Weiterbildung des Erfindungsgegenstandes kann man das Vielfachmessgerät durch den Einbau des Messbereichsschalters in die Anzeigebaugruppe wesentlich verbessern. Durch diese Massnahme gelingt es, die Bedienung des Gerätes zu vereinfachen, da sowohl die Anzeige wie auch der Messbereichsschalter in der gleichen Blickrichtung angeordnet sind. Wesentlich ist jedoch, dass der Messbereichsschalter innerhalb der Anzeigebaugruppe möglichst wenig Platz beansprucht und gut zu betätigen ist. Der Bedienknopf des Messbereichsschalters ist deshalb in einer Aussparung des Gehäuses der Anzeigebaugruppe derart eingefügt, dass seine Drehebene im rechten Winkel zur Anzeigeebene liegt und der Bedienungsknopf von mindestens zwei Seiten des Gehäuses ergreifbar ist.

Besonders gut zugänglich ist der Bedienungsknopf des Messbereichsschalters, wenn er in einer der beiden äusseren Ecken der Anzeigebaugruppe eingefügt ist. Die Bedienung wird weiterhin erleichtert, wenn die Gehäuseform im Bereich der Gehäuseaussenkanten der Rundung des Bedienungsknopfes angepasst ist, da dann keine Kanten und Ecken die Bedienung stören.

Es ist zweckmässig, ausser dem Messbereichsschalter, auch alle übrigen Bedienfunktionen des Vielfachmessgerätes in der gleichen Ebene wie die Messwertanzeige anzuordnen.

Die elektrische Sicherheit des Gerätes wird dadurch erhöht, dass die Gehäuse von Anzeigebaugruppe und Hilfsbaugruppe durch einen Faltenbalg aus gummielastischem Material miteinander verbunden sind, der das Scharnier spritzwasserdicht abdeckt.

Eine wesentliche Erhöhung des Bedienkomforts wird dadurch erreicht, dass in einem Teilbereich des Traggurtes Messleitungen angeordnet sind, die im Bereich der Befestigungsstelle des Traggurtes mit dem Messgerät elektrisch verbunden sind. Die Messleitungen treten etwa in Schulterhöhe aus dem Traggurt aus und sind bis zu den Messspitzen herab als dehnbare Spiralkabel gestaltet. Da am Messgerät zusätzlich Halterungen zum Einstecken der Messspitzen vorgesehen sind, wird ein unkontrolliertes Umherpendeln nicht benutzter Messspitzen vermieden. Somit ist einerseits eine Gefährdung durch die Messleitungen ausgeschlossen und andererseits sind die Messspitzen stets griffbereit. Der Traggurt ist in der Mitte durch eine Verbindungsvorrichtung teilbar gestaltet, so dass er auch bei Verwendung des Vielfachmessgerätes auf einem Arbeitstisch nicht hinderlich ist.

Zur besseren Befestigung der Messspitzen am Messgerät bzw. am Traggurt, können diese mit Halteöffnungen versehen werden, in die jeweils ein Haltedorn z.B. nach dem Prinzip eines Druckknopfes eingreift. Bei längeren Transportwegen zum jeweiligen Einsatzort können damit die Messspitzen unverlierbar gesichert werden, d.h. ein Umherpendeln der Messleitungen wird vermieden.

An der von der Anzeigebaugruppen abgewandten Seite der Hilfsbaugruppe kann eine Ansteckeinheit befestigt werden. Diese kann Zusatzeinheiten z.B. eine Batterie oder ein Netzgerät zur Stromversorgung aufnehmen. Das zusätzliche Gewicht sowie der Befestigungsort der Ansteckeinheit bewirken eine zusätzliche Stabilisierung der Lage bei hängendem Vielfachmessgerät.

Weitere Einzelheiten und Vorteile des Erfindungsgegenstandes sind anhand eines Ausführungsbeispieles der Erfindung in der Zeichnung dargestellt und werden im folgenden näher dargestellt: Es zeigen:

Fig. 1 ein Vielfachmessgerät an einem Traggurt hängend, wobei die Anzeigebaugruppe zur ersten Seite hin geschwänkt ist,

Fig. 2 ein Vielfachmessgerät mit geteiltem Traggurt, bei dem die Anzeigebaugruppe und die Hilfsbaugruppe in der gleichen Ebene liegen und

Fig. 3 das Vielfachmessgerät auf einem Tisch liegend, wobei die Anzeigebaugruppe zur zweiten Seite hin geschwenkt ist und einem in der Mitte getrennten Traggurt.

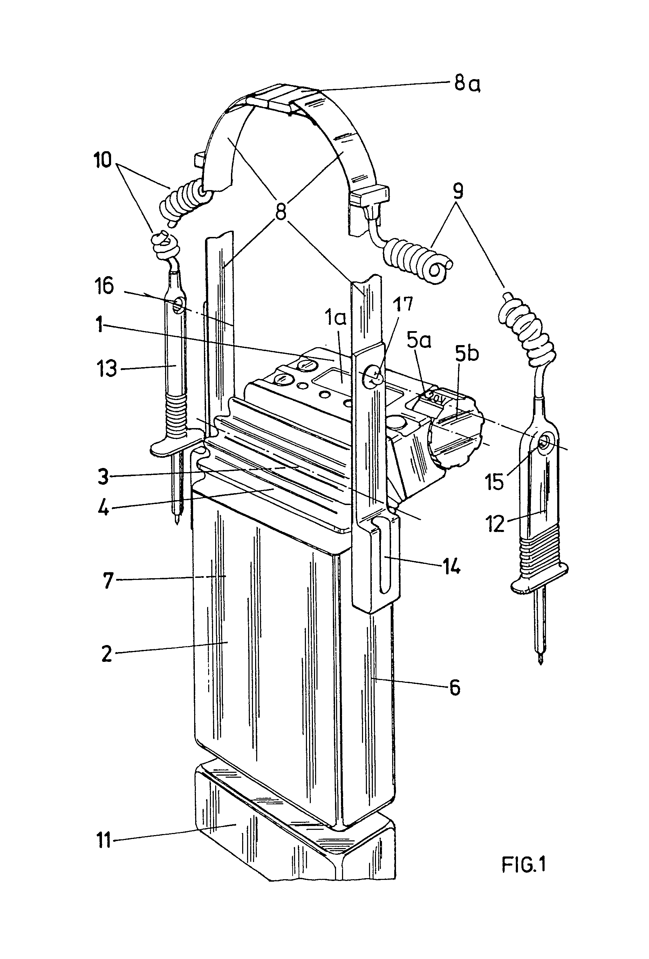

Fig. 1 zeigt das Vielfachmessgerät in einer Stellung, wie es um den Hals getragen wird. Die Anzeigebaugruppe 1 ist gegenüber der Hilfsbaugruppe 2 zur ersten Seite hin geschwenkt, derart, dass die Anzeige nach oben zu liegen kommt. Das die beiden Baugruppen 1, 2 verbindende Scharnier 3 ist in der Zeichnung nicht sichtbar, da es von dem Faltenbalg 4 umschlossen ist. Der Faltenbalg erlaubt beliebige Schwenkbewegungen der beiden Baugruppen und sorgt für eine gute Abdichtung ihrer Gehäuse gegenüber Staub und Spritzwasser.

An der Hilfsbaugruppe 2 ist beidseitig in Nähe des Scharniers 3 der Traggurt 8 befestigt. Zwei Messleitungen sind im Bereich der Befestigungsstellen des Traggurtes 8 elektrisch mit der Hilfsbaugruppe verbunden und in einem Teilbereich des Traggurtes in diesen eingebettet. In Schulterhöhe treten die Messleitungen aus dem Traggurt 8 aus und sind dann als dehnbare Spiralkabel 9, 10, gestaltet, an deren Ende je eine Messspitze 12, 13 befestigt ist.

Am Traggurt 8 bzw. an der Hilfsbaugruppe 2 ist eine Halterung 14 vorgesehen, in welche die Messspitzen 12, 13 einsteckbar sind. Eine zusätzliche Befestigung der Messspitzen 12, 13 ist durch einen Haltedorn 17 und eine Öffnung 15 möglich. Solange die Messspitzen 12, 13 nicht gebraucht werden, sind sie also sicher aufgehoben und können nicht unkontrolliert herumpendeln. Andererseits sind sie jederzeit griffbereit und können durch die dehnbaren Spiralkabel 9, 10 auch bequem an die Messstelle herangeführt werden.

Alle Bedienfunktionen, insbesondere der Messbereichsschalter 5, sind in der Anzeigebaugruppe 1 angeordnet. Somit liegen alle Anzeigeelemente in einer Ebene, sind also aus einer Blickrichtung zu überschauen. Der Bedienungsknopf 5b des Messbereichsschalters 5 ist für die rechte Hand gut greifbar in der äusseren rechten Ecke der Anzeigebaugruppe angeordnet. Die Messbereichsanzeige 5a erfolgt unmittelbar über den Bedienknopf 5b und wird durch seine Drehung in die gleiche Ebene wie die Messwertanzeige 1a geschwenkt.

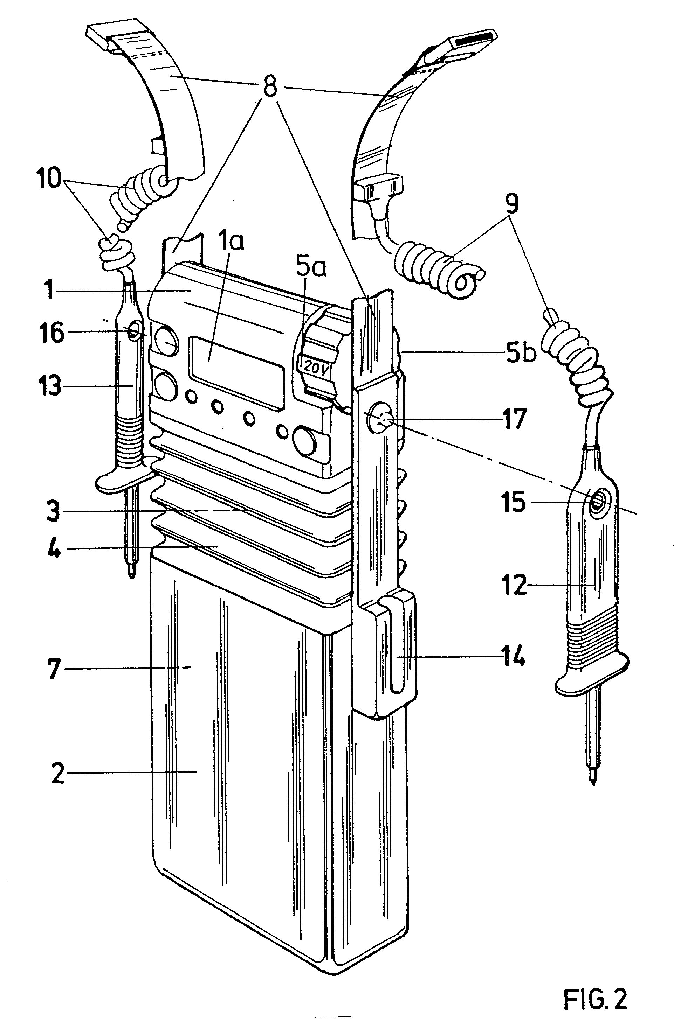

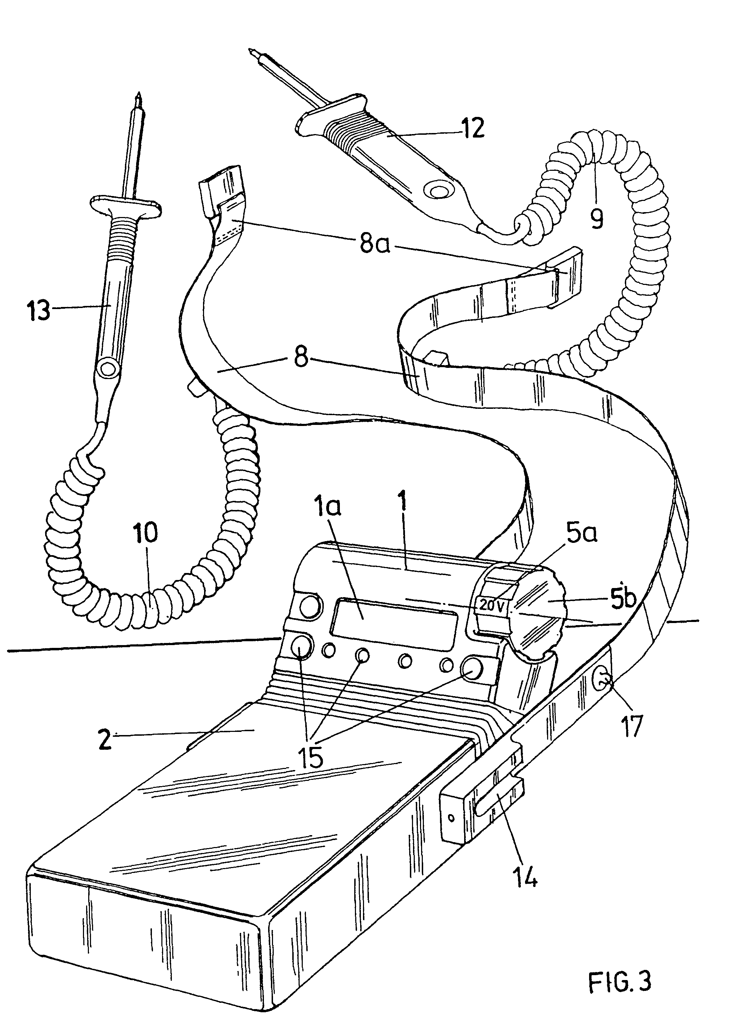

In Figur 2 ist die Anzeigegruppe 1 nach oben in die gleiche Ebene wie die Hilfsbaugruppe 2 geschwenkt. Es handelt sich hierbei um eine Zwischenstellung zwischen den beiden Gebrauchsstellungen der Figuren 1 und 3.

Figur 3 zeigt das Vielfachmessgerät in der zweiten Gebrauchslage auf einem Tisch liegend. Die Anzeigebaugruppe 1 ist nunmehr zur zweiten Seite der Hilfsbaugruppe 2 hin geschwenkt. Der Winkel, den die beiden Baugruppen 1, 2 miteinander bilden, richtet sich nach der Sitzposition des Benutzers und kann beliebig eingestellt werden. Damit der volle Aktionsradius der an den Spiralkabeln 9, 10 befestigten Messspitzen 12, 13 ausgenutzt werden kann, ist der Traggurt 8 in der Mitte teilbar. Hierzu dient eine Verbindungsvorrichtung 8a die sowohl geöffnet wie auch wieder geschlossen werden kann.

Wie in Fig. 1 dargestellt, kann mit der Hilfsbaugruppe 2 noch eine Ansteckeinheit 11 verbunden werden, die z.B. zur Aufnahme einer zusätzlichen Hilfsstromquelle dient.

**Patentansprüche**

1. Vielfachmessgerät mit schwenkbarer Anzeige und Traggurt (8), bei dem sowohl die zur Sichtbarmachung des Messwertes einer zu untersuchenden Messgrösse dienende Anzeigebaugruppe (1) wie auch eine zur Messung benötigte Hilfsbaugruppe (2) ein eigenes Gehäuse besitzen und beide Gehäuse durch ein Scharnier (3) miteinander verbunden sind, derart, dass sie in eine gemeinsame Ebene sowie in verschiedene einen Winkel einschliessende Ebenen schwenkbar sind, dadurch gekennzeichnet, dass die Anzeigebaugruppe (1) relativ zur Ebene der Hilfsbaugruppe (2) beidseitig in verschiedene Stellungen schwenkbar ist, und der Traggurt (8) in Scharniernähe befestigt ist, und Abmessungen und Gewicht der Hilfsbaugruppe (2) im Verhältnis zur Anzeigebaugruppe (1) so gewählt sind, dass der Schwerpunkt des Vielfachmessgerätes im Bereich der Hilfsbaugruppe (2) liegt, derart, dass die Hilfsbaugruppe (2) am Traggurt (8) in ihrer Längserstreckung nach unten hängt und die Anzeigebaugruppe (1) oberhalb der Hilfsbaugruppe (2) liegt.

2. Vielfachmessgerät nach Anspruch 1, dadurch gekennzeichnet, dass in die Anzeigebaugruppe (1) ein Messbereichsschalter (5) eingebaut ist und die Messbereichsanzeige (5a) in der gleichen Ebene wie die Messwertanzeige (1a) erfolgt.

3. Vielfachmessgerät nach Anspruch 1 oder 2, dadurch gekennzeichnet, dass der Bedienungsknopf (5b) des Messbereichsschalters (5) in eine Aussparung des Gehäuses der Anzeigebaugruppe (1) derart eingefügt ist, dass seine Drehebene im rechten Winkel zur Anzeigeebene liegt und der Bedienungsknopf (5b) von mindestens zwei Seiten des Gehäuses aus greifbar ist.

4. Vielfachmessgerät nach einem der vorhergehenden Ansprüche, dadurch gekennzeichnet, dass der Bedienungsknopf (5b) des Messbereichsschalters (5) in eine der beiden äusseren Ecken der Anzeigebaugruppe (1) eingefügt ist und die Gehäuseform im Bereich der Gehäuseaussenkanten der Rundung des Bedienungsknopfes (5b) angepasst ist.

5. Vielfachmessgerät nach einem der vorhergehenden Ansprüche, dadurch gekennzeichnet, dass Bedienanzeigen aller Bedienfunktionen (15) des Vielfachmessgerätes in der gleichen Ebene wie die Messwertanzeige (1a) liegen.

6. Vielfachmessgerät nach einem der vorgehenden Ansprüche, dadurch gekennzeichnet, dass die Gehäuse von Anzeigebaugruppe (1) und Hilfsbaugruppe (2) durch einen Faltenbelag (4) aus gummielastischem Material miteinander verbunden sind, der das Scharnier spritzwasserdicht abdeckt.

7. Vielfachmessgerät nach einem der vorhergehenden Ansprüche, dadurch gekennzeichnet, dass in einem Teilbereich des Traggurtes (8) Messleitungen angeordnet sind, die im Bereich der Befestigungsstelle des Traggurtes (8) mit der Hilfsbaugruppe (2) elektrisch verbunden sind und am Traggurt (8) etwa in Schulterhöhe der Bedienungsperson austreten und zu Messspitzen (12, 13) führen.

8. Vielfachmessgerät nach einem der vorhergehenden Ansprüche, dadurch gekennzeichnet, dass der zwischen Traggurt (8) und Messspitzen (12, 13) liegende Teil der Messleitung als dehnbares Spiralkabel (9, 10) gestaltet ist.

9. Vielfachmessgerät nach einem der vorhergehenden Ansprüche, dadurch gekennzeichnet, dass am Messgerät für beide Messspitzen (12, 13) je eine Halterung (14) vorgesehen ist, die zur Befestigung nicht benutzter an Messleitungen hängender Messspitzen (12, 13) dient.

10. Vielfachmessgerät nach einem der vorhergehenden Ansprüche, dadurch gekennzeichnet, dass der Traggurt (8) in der Mitte durch eine Verbindungsvorrichtung (8a) teilbar und wieder zusammenfügbar ist.

11. Vielfachmessgerät nach einem der vorhergehenden Ansprüche, dadurch gekennzeichnet, dass die Griffteile der Messspitzen (12, 13) Halteöffnungen (15, 16) aufweisen, die jeweils an einem Haltedorn (17) die Messspitzen (12, 13) an beiden Seiten des Gehäuses der Hilfsbaugruppe sichern.

12. Vielfachmessgerät nach einem der vorhergehenden Ansprüche, dadurch gekennzeichnet, dass an der von der Anzeigebaugruppe (1) abgewandten Seite der Hilfsbaugruppe (2) eine Ansteckeinheit (11) befestigbar ist.

13. Vielfachmessgerät nach Anspruch 1, dadurch gekennzeichnet, dass der Messbereichsschalter (5) in die Anzeigebaugruppe (1) eingebaut ist und die Messbereichsanzeige (5a) in der gleichen Ebene wie die Messwertanzeige (1a) erfolgt und der Bedienknopf (5b) des Messbereichsschalters (5) in einer Aussparung des Gehäuses der Anzeigebaugruppe (1) derart eingefügt ist, dass seine Drehebene im rechten Winkel zur Anzeigeebene liegt und der Bedienknopf (5b) von mindestens zwei Seiten des Gehäuses ergreifbar ist.

## Claims

1. Multi-function instrument with swivelling indicator and carrying strap (8), in which both the indicator assembly (1), serving to display the measured value of a measurable variable to be investigated, and an auxiliary assembly (2), required for the measurement, have their own housing and the two housings are connected to each other by a hinge (3) in such a way that they can be swivelled into a common plane and into different planes enclosing an angle, characterized in that the indicator assembly (1) can be swivelled relative to the plane of the auxiliary assembly (2) on either side into various positions, and the carrying strap (8) is fastened near to the hinge, and dimensions and weight of the auxiliary assembly (2) are chosen in relation to the indicator assembly (1) in such a way that the centre of gravity of the multi-function instrument lies in the region of the auxiliary assembly (2) in such a way that the auxiliary assembly (2) hangs on the carrying strap (8) downward in its longitudinal extent and the indication assembly (1) lies above the auxiliary assembly (2).

2. Multiple-function instrument according to Claim 1, characterized in that a measuring range switch (5) is built into the indicator assembly (1) and the measuring range indication (5a) is performed in the same plane as the measured value indication (1a).

3. Multiple-function-instrument according to Claim 1 or 2, characterized in that the control knob (5b) of the measuring range switch (5) is inserted in a recess of the housing of the indicator assembly (1) in such a way that its plane of rotation is at right angles to the plane of indication and the control knob (5b) is accessible from at least two sides of the housing.

4. Multiple-function instrument according to one of the preceding claims, characterized in that the control knob (5b) of the measuring range switch (5) is inserted in one of the two outer corners of the indication assembly (1) and the shape of the housing in the region of the outer housing edges is adapted to the rounding of the control knob (5b).

5. Multi-function instrument according to one of the preceding claims, characterized in that control indications of all control functions (15) of the multifunction instrument are in the same plane as the measured value indication (1a).

6. Multi-function instrument according to one of the preceding claims, characterized in that the housings of indication assembly (1) and auxiliary assembly (2) are connected to each other by a bellows (4) of elastomeric material, which covers the hinge in a splash-proof manner.

7. Multi-function instrument according to one of the preceding claims, characterized in that instrument leads are arranged in a portion of the carrying strap (8), which leads are electrically connected in the region of the fastening point of the carrying strap (8) with the auxiliary assembly (2) and leave the carrying strap (8) approximately at shoulder height of the operator and lead to probes (12, 13).

8. Multi-function instrument according to one of the preceding claims, characterized in that the part of the instrument lead lying between the carrying strap (8) and probes (12, 13) is designed as extensible spiral cable (9, 10).

9. Multi-function instrument according to one of the preceding claims, characterized in that a mount (14) is provided on the instrument for each of the two probes (12, 13) and is to be used for attaching probes (12, 13) suspended on instrument leads but not in use.

10. Multi-function instruments according to one of the preceding claims, characterized in that the carrying strap (8) can be separated and joined together again in the middle by a connecting device (8a).

11. Multi-function instrument according to one of the preceding claims, characterized in that the handle parts of the probes (12, 13) have retention openings (15, 16) which secure the probes (12, 13) in each case on a retaining log (17) on either side of the housing of the auxiliary assembly.

12. Multi-function instrument according to one of the preceding claims, characterized in that an attachment unit (11) can be fastened on the side of the auxiliary assembly (2) facing away from the indication assembly (1).

13. Multi-function instrument according to Claim 1, characterized in the measuring range switch (5) is built into the indication assembly (1) and the measuring range indication (5a) is performed in the same plane as the measured value indication (1a) and the control knob (5b) of the measuring range switch (5) is inserted in a recess of the housing of the indication assembly (1) in such a way that its plane of rotation is at right angles to the plane of indication and the control knob (5b) is accessible from at least two sides of the housing.

**Revendications**

1. Contrôleur universel à affichage pivotable et bretelle (8), dans lequel, aussi bien le module d'affichage (1) servant à visualiser la valeur mesurée d'une grandeur à déterminer qu'un module auxiliaire (2) utilisé pour la mesure, comportent leur propre boîtier, les deux boîtiers étants mutuellement raccordés par une charnière (3) de manière à pouvoir être pivotés et placés dans un plan commun de même que dans différents plans formant un angle, caractérisé par le fait que le module d'affichage (1) peut pivoter des deux côtes dans différentes positions relativement au plan du module auxiliaire (2), que la bretelle (8) est fixée à proximité de la charnière et que les dimensions et le poids du module auxiliaire (2) sont choisis par rapport au module d'affichage (1) de telle sorte que le centre de gravité du contrôleur universel se situe dans la zone du module auxiliaire (2) de façon que le module auxiliaire (2) suspendu à la bretelle (8) pende vers le bas dans le sens de sa longueur avec le module d'affichage (1) au-dessus du module auxiliaire (2).

2. Contrôleur universel selon la revendication 1, caractérisé par le fait que dans le module d'affichage (1) est incorporé un commutateur (5) des zones de mesure et que l'affichage (5a) des zones de mesure s'effectue dans le même plan que l'affichage (1a) des valeurs mesurées.

3. Contrôleur universel selon la revendication 1 ou 2, caractérisé par le fait que le bouton de commande (5b) du commutateur (5) des zones de mesure est inséré dans un évidement du boîtier du module d'affichage (1), que son plan de rotation se situe à angle droit par rapport au plan d'affichage et que le bouton de commande (5b) peut être saisi par au moins deux côtés du boîtier.

4. Contrôleur universel selon l'une des revendications précédentes, caractérisé par le fait que le bouton de commande (5b) du commutateur (5) des zones de mesure est inséré dans l'un des deux angles extérieurs du module d'affichage (1) et que la forme du boîtier dans la zone de ses arêtes extérieures est adaptée à la rondeur du bouton de commande (5b).

5. Contrôleur universel selon l'une des revendications précédentes, caractérisé par le fait que les affichages de tous les organes de commande (5b) du contrôleur universel se situent dans le même plan que l'affichage (1a) des valeurs mesurées.

6. Contrôleur universel selon l'une des revendications précédentes, caractérisé par le fait que les boîtiers du module d'affichage (1) et du module auxiliaire (2) sont mutuellement raccordés par un soufflet (4) qui est réalisé en un matériau ayant l'élasticité du caoutchouc et qui recouvre la charnière de façon étanche aux projections d'eau.

7. Contrôleur universel selon l'une des revendications précédentes, caractérisé par le fait que dans une zone partielle de la bretelle (8) sont disposées des lignes de mesure qui sont électriquement raccordées au module auxiliaire (2), dans la zone du point de fixation de la bretelle (8), sortent de la bretelle (8) à peu près à la hauteur de l'épaule de l'utilisateur et aboutissent aux pointes de mesure (12, 13).

8. Contrôleur universel selon l'une des revendications précédentes, caractérisé par le fait que la partie de la ligne de mesure qui se trouve entre la bretelle (8) et les pointes de mesure (12, 13) est réalisée sous la forme d'un fils torsadé extensible (9, 10).

9. Contrôleur universel selon l'une des revendications précédentes, caractérisé par le fait que, pour les deux pointes de mesure (12, 13), il est respectivement prévu sur l'appareil de mesure un support (14) qui sert à la fixation des pointes de mesure (12, 13) non utilisées suspendues aux lignes de mesure.

10. Contrôleur universel selon l'une des revendications précédentes, caractérisé par le fait que la bretelle (8) peut être séparée en deux en son milieu et à nouveau réunie par un dispositif de raccordement (8a).

11. Contrôleur universel selon l'une des revendications précédentes, caractérisé par le fait que les parties servant à la préhension des pointes de mesure (12, 13) comportent des oeillets (15, 16) qui servent à assujettir respectivement les pointes de mesure (12, 13) sur un bouton (17) prévu de chaque côté du boîtier du module auxiliaire.

12. Contrôleur universel selon l'une des revendications précédentes, caractérisé par le fait qu'un bloc connecteur (11) peut être fixé sur le côté du module auxiliaire (2) qui est à l'opposé du module d'affichage (1).

13. Contrôleur universel selon la revendication 1, caractérisé par le fait que le commutateur (5) des zones de mesure est incorporé au module d'affichage (1) et que l'affichage (5a) des zones de mesure s'effectue dans le même plan que l'affichage (1a) des valeurs mesurées, que le bouton de commande (5b) du commutateur (5) des zones de mesure est inséré dans un évidement du boîtier du module d'affichage (1) de manière que son plan de rotation se situe à angle droit par rapport au plan d'affichage et que le bouton de commande (5b) peut être saisi par au moins deux côtés du boîtier.

FIG.1

0 100 949

FIG. 2

9

FIG. 3